(19) **Europäisches Patentamt**

**European Patent Office**

**Office européen des brevets**

(11) Veröffentlichungsnummer: **0 271 163 B1**

(12) **EUROPÄISCHE PATENTSCHRIFT**

(45) Veröffentlichungstag der Patentschrift: **11.09.91**

(21) Anmeldenummer: **87202440.1**

(22) Anmeldetag: **07.12.87**

(51) Int. Cl.⁵: **H05K  3/04**, H05K 3/10, H05K 3/28, H05K 3/00

(54) **Verfahren zum Herstellen von elektrischen Schaltungsplatten.**

(30) Priorität: **09.12.86 DE 3641995**

(43) Veröffentlichungstag der Anmeldung:
**15.06.88 Patentblatt  88/24**

(45) Bekanntmachung des Hinweises auf die
Patenterteilung:
**11.09.91 Patentblatt  91/37**

(84) Benannte Vertragsstaaten:
**DE FR GB IT**

(56) Entgegenhaltungen:
**DE-A- 2 305 883**
**DE-A- 3 306 120**
**FR-A- 2 361 007**
**GB-A- 816 458**
**US-A- 3 628 243**

(73) Patentinhaber: **Philips Patentverwaltung
GmbH
Wendenstrasse 35 Postfach 10 51 49
W-2000 Hamburg 1(DE)**

(84) Benannte Vertragsstaaten:
**DE**

Patentinhaber: **N.V. Philips' Gloeilampenfabrieken
Groenewoudseweg 1
NL-5621 BA Eindhoven(NL)**

(84) Benannte Vertragsstaaten:
**FR GB IT**

(72) Erfinder: **Martin, Johann
Markschiedsweg 27
W-6336 Solms/Oberbiel(DE)**

(74) Vertreter: **Kupfermann, Fritz-Joachim,
Dipl.-Ing. et al
Philips Patentverwaltung GmbH Wendenstrasse 35 Postfach 10 51 49
W-2000 Hamburg 1(DE)**

## Beschreibung

Die Erfindung bezieht sich auf ein Verfahren zum Herstellen von elektrischen Schaltungsplatten, die aus einem plattenförmigen Kunststoffträger und mit diesem verbundenen, ein Schaltungsmuster bildenden, flächenhaften Leitungszügen bestehen, die Kontaktstellen für mit ihnen zu kontaktierende Bauelemente aufweisen, wobei das Schaltungsmuster in einem Schneidwerkzeug mit Schneidstempeln und Niederhaltern aus einer Kupferplatte geschnitten und in Kunststoff eingespritzt wird und wobei der Kunststoff den plattenförmigen (auch andere Körperformen, z. B. Gehäuse) Träger bildet.

Es ist aus der DE-OS 23 05 883 eine Leiterplatte für elektrische Schaltungen bekannt, bei der die stromleitenden Bahnen innerhalb einer Trägerplatte angeordnet sind. Die Leiterplatte wird in der Art hergestellt, daß die Leiterbahnen aus einer Metallplatine ausgeschnitten werden, wobei ein geschlossener Halterahmen gebildet wird, in welchem die Leiterbahnen zur Fixieerung ihrer Lage verbunden bleiben. Beim Ausstanzen verbleiben an der Metallplatine nur die später Leiterbahnen bildenden kupfernen Leitungszüge. Alle übrigen Teile der Metallplatte, die später nicht gebraucht werden, sind Stanzabfall, der weggeworfen wird. Die Metallplatine mit ihren verbliebenen, vom Halterahmen festgehaltenen Leitungszügen wird anschließend eine Preßform eingebracht. Die Leitungszüge werden dann mit Kunststoff umspritzt, der die spätere Trägerplatte bildet.

Dieses Herstellungsverfahren ist von mehr theoretischer Art. Es zeigt sich nämlich, daß bei komplizierteren Leitungsmustern der Halt des geschlossenen Halterahmens nicht ausreicht. Innerhalb dieses Halterahmens fliegen die Leitungszüge mehr oder weniger durcheinander, so daß eine brauchbare Einspannung innerhalb der Preßform unmöglich wird. Ein weiterer Nachteil besteht darin, daß die ausgestanzten Plattenteile Abfall sind.

Es ist Aufgabe der Erfindung, ein Verfahren zum Herstellen von elektrischen Schaltungsplatten oder andere Formen zu schaffen, bei dem aus einer Kupferplatte herausgearbeitete Leitungszüge zuverlässig in eine Spritzform einspannbar und in dieser umspritzbar sind.

Die gestellte Aufgabe ist erfindungsgemäß dadurch gelöst, daß die Kupferplatte nur in einem Teilschnitt eingeschnitten wird unter Aufrechterhaltung eines noch zusammenhängenden Gefüges aus späteren Stromleitungszügen des Schaltungsmusters und dazwischen befindlichen Leerzügen und daß dieses Gefüge in eine Kunststoffspritzform mit Distanzstücken in Formhohlraum eingelegt wird, wobei die Distanzstücke die Stromleitung und Leerzüge im Formhohlraum auseinanderdrücken in mindestens zwei gegeneinander versetzte Ebenen, in denen die Züge während des Kunststoffspritzvorganges von den Distanzstücken festgehalten werden.

Bei diesem Herstellungsverfahren verbleibt auch nach dem Teilschnitt noch ein ausreichend fester Zusammenhalt zwischen den einzelnen Stromleitungs- und Leerzügen, so daß die Leitungzüge sicher in die Spritzform eingebracht werden können, in der dann die Distanzstücke die einzelnen Züge auseinanderdrücken in die gewünschte ·Lage. Das Verfahren beruht darauf, daß wie bei einem vorbereiteten, noch nicht durchtrennten Puzzle beim Teilschnitt die einzelnen Schnitte bereits materialgefügemäßig vollzogen, die Teile jedoch haftungsmäßig noch nicht voneinander getrennt sind.

Nach einer weiteren Ausgestaltung der Erfindung wird dies erreicht, wenn die Schneidwege der Schneidstempel eine Länge etwa in der Größenordnung der halben Kupferplatte aufweisen.

Das sonst als Abfall ausgestanzte Material der Leerzüge wird in diesem Fall nutzbringend angewendet, indem diese Leerzüge beispielsweise nach außen wärmeleitend kontaktiert werden und somit zur Kühlung der Schaltungsplatte Verwendung finden.

Nach einer weiteren Ausgestaltung der Erfindung ist vorgesehen, daß mittels leistenförmiger abdeckender Schieber Teile von Leitungszügen von Kunststoff freigehalten werden. Derartige, von Kunststoff freigehaltene Bereich ermöglichen es, einzelne Plattenteile nach dem Spritzen, Bestücken und Löten gegeneinander abzuwinkeln.

Nach einer weiteren Ausgestaltung der Erfindung ist vorgesehen, daß in wenigstens einen Teil der Kontaktstellen der Stromleitungszüge vor dem Teilschnitt düsenförmige Aufweitungen eingezogen werden. Derartige düsenartige Aufweitungen, die dann, wenn von einem plattenförmigen Kufpermaterial ausgegangen wird, möglich sind, erleichtern später das Einstecken von Bauteil-Anschlußdrähten.

Die Erfindung wird anhand des in der Zeichnung dargestellten Ausführungsbeispieles näher erläutert. Es zeigen:

Fig. 1 schematisch das teilweise Einschneiden einer Kupferplatte in einem Mehrfach-Stanzwerkzeug zur Bildung einzelner Stromleitungs- und Leerzüge,

Fig. 2 das Einspannen der durch das Einschneiden gebildeten einzelnen Leitungszüge in einem Kunststoff-Spritzwerkzeug, in dem eine Schaltungsplatte mit mehreren Leitungsebenen gespritzt wird,

Fig. 3 eine fertig gespritzte Schaltungsplatte mit hervorstehenden Anschlußfahnen,

Fig. 4 eine in die Kupferplatte eingezogene Düse.

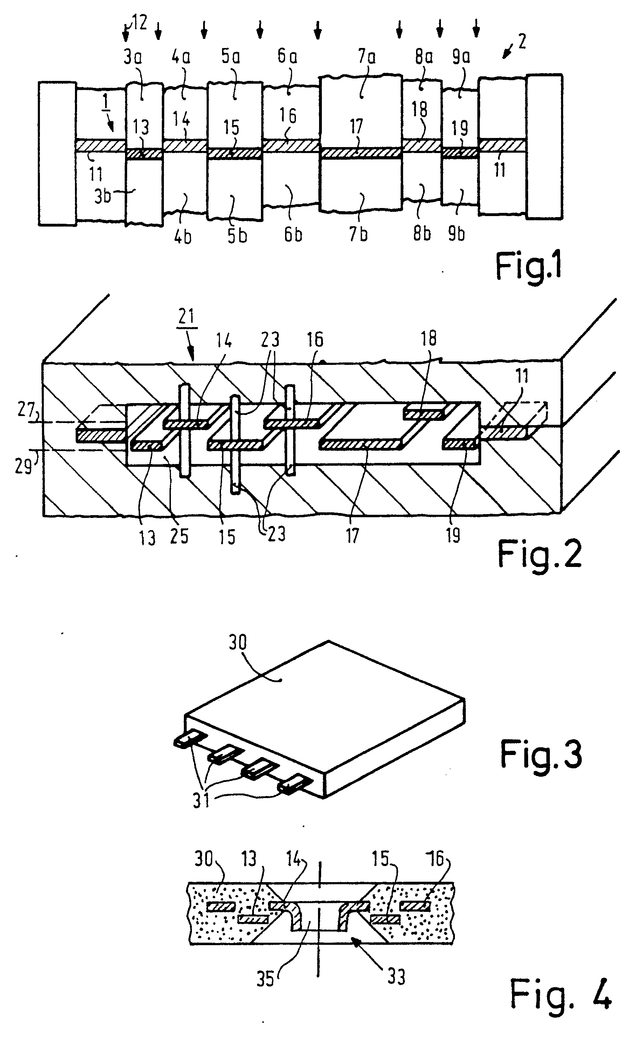

Zur Herstellung einer im Kunststoffspritzverfahren hergestellten Schaltungsplatte mit Leitungszügen in mehreren Ebenen wird ausgegangen von einer Kupferplatte 1, die in ein Stanzwerkzeug 2 eingelegt wird. Das Stanzwerkzeug hat mehrere Sätze von Stanzstempeln 3a, 3b, 4a, 4b, 5a, 5b, 6a, 6b, 7a, 7b, 8a, 8b, 9a, 9b. Mit Hilfe dieser Stanzstempelsätze, die nur beispielhaft angedeutet sind, wird in die vorzugsweise oberflächenverzinnte Kupferplatte 1 innerhalb eines zunächst stehenbleibenden Randes 11 längs Schnittkanten 12, die durch Pfeile oberhalb der Darstellung von Fig. 1 angegeben sind, eingeschnitten. Das Einschneiden erfolgt dabei nur so weit, daß einzelne zu bildende Stromleitungs- oder Leerzüge 13 bis 19 nicht voneinander getrennt werden. Das Einschneiden geht nur so weit, daß das Gefüge längs der Schnittlinien 12 gebrochen wird. Bei diesem Einschneid-, jedoch nicht Durchschneidvorgang, der in der Größenordnung der halben Kupferplattendicke liegt, bleibt die Kupferplatte 1 noch als Platte erhalten und ist gut manipulierbar. Nach dem Herausnehmen der in dieser Weise eingeschnittenen Kupferplatte 1 aus dem Werkzeug werden die einzelnen Leitungs-oder Leerzüge mittels des sich ringsherum erstreckenden Randes 11 zusätzlich zusammengehalten.

Die in Leitungs- und Leerzüge 11 bis 13 aufgeteilte Kupferplatte wird nun mit ihrem noch bestehenden zusammenhängenden Gefüge in den Formhohlraum 25 in ein Spritzwerkzeug 21 eingelegt. Das Spritzwerkzeug ist mit Distanzstücken 23 versehen, die von oben und unten innerhalb des Formhohlraumes 25 gegen die einzelnen Leitungszüge drücken und diese innerhalb des Spritzhohlraumes 25 in vorgegebene Ebenen 27 und 29 drücken. Dabei werden die einzelnen Züge 11 bis 13 längs der Schnittlinien völlig voneinander getrennt.

Es ist selbstverständlich möglich, abweichend von den zwei dargestellten Ebenen 27, 29 auch weitere Ebenen für Leitungs- und Leerzüge vorzusehen. Der Kunststoff, der in das Spritzwerkzeug 21 eingespritzt wird, richtet sich in seiner Art nach den an ihn gestellten Anforderungen.

Für das Herstellungsverfahren ist es gleichgültig, ob die im Rahmen des Einschneidens gebildeten Züge 13 bis 19 Leitungs- oder Leerzüge sind. Jeder der Leitungs- oder Leerzüge 13 bis 19 kann entweder ein Leitungszug oder ein Leerzug sein. Ebenso ist es möglich, die Ebene 27 als Stromleitungszugebene und die Ebene 29 als Leerzugebene oder umgekehrt vorzusehen. Es ist aber auch möglich, eine Mischung von beiden entsprechend den Anforderungen der Schaltung einzusetzen.

Fig. 3 zeigt, wie die Schaltungsplatte nach dem Herausnehmen aus dem Spritzwerkzeug 21 aussehen kann ohne das Herausarbeiten von besonderen Anschlußöffnungen oder dergleichen. Der Rand 11 ist abgeschnitten, und es verbleiben dann lediglich Anschlußfahnen 31, die entweder zum Verbinden mit Stromleitungszügen anderer Schaltungsplatten dienen oder die mit Wärmeleitern außerhalb der Schaltungsplatte, beispielsweise einem Gehäuse oder Kühlrippen, Verbindung bekommen können.

Fig. 4 zeigt, wie Anschlußstellen 33 für Bauelemente vor dem Einschneiden nach Fig. 1 vorbereitet werden können zur Erleichterung des Einsteckens von Bauteil-Anschlußdrähten. Fig. 4 zeigt hierzu eine düsenartige Einziehung 35.

**Patentansprüche**

1. Verfahren zum Herstellen von elektrischen Schaltungsplatten, die aus einem plattenförmigen Kunststoffträger und mit diesem verbundenen, ein Schaltungsmuster bildenden, flächenhaften Leitungszügen bestehen, die Kontaktstellen für mit ihnen zu kontaktierende Bauelemente aufweisen, wobei das Schaltungsmuster in einem Schneidwerkzeug mit Schneidstempeln und Niederhaltern aus einer Kupferplatte geschnitten und in Kunststoff eingespritzt wird und wobei der Kunststoff den plattenförmigen Träger bildet, dadurch gekennzeichnet, daß die Kupferplatte nur in einem Teilschnitt eingeschnitten wird unter Aufrechterhaltung eines noch zusammenhängenden Gefüges aus späteren Stromleitungszügen des Schaltungsmusters und dazwischen befindlichen Leerzügen und daß dieses Gefüge in eine Kunststoffspritzform mit Distanzstücken im Formhohlraum eingelegt wird, wobei die Distanzstücke die Stromleitungs- und Leerzüge im Formhohlraum auseinanderdrücken in mindestens zwei gegeneinander versetzte Ebenen, in denen die Züge während des Kunststoffspritzvorganges von den Distanzstücken festgehalten werden.

2. Verfahren nach Anspruch 1, dadurch gekennzeichnet, daß die Schneidwege der Schneidstempel eine Länge etwa in der halben Größenordnung der Kupferplatte aufweisen.

3. Verfahren nach Anspruch 1, dadurch gekennzeichnet, daß mittels leistenförmiger abdeckender Schieber Teile von Leiterzügen von Kunststoff freigehalten werden.

4. Verfahren nach Anspruch 1, dadurch gekennzeichnet, daß in wenigstens einen Teil der Kontaktstellen der Stromleitungszüge vor dem Teilschnitt düsenförmige Aufweitungen eingezogen werden.

5. Mit Hilfe des Vefahrens nach den Ansprüchen 1 und 2 hergestellte Schaltungsplatte, dadurch gekennzeichnet, daß ein Teil der Leerzüge als Wärmeleiter ausgebildet und am Plattenrand mit Anschlußfahnen herausgeführt ist.

## Claims

1. A method of manufacturing electrical circuit boards comprising a plate-shaped carrier of synthetic material and planar conductor tracks, which are connected to this carrier, constitute a circuit pattern and have contact areas for components to be contacted with them, the circuit pattern being cut from a copper plate in a cutting device with punching dies and hold-down elements and being enveloped in injection-moulded synthetic material, the synthetic material constituting the plate-shaped carrier, characterized in that the copper plate is incised only partly whilst maintaining a still coherent assembly of subsequent current conductor tracks of the circuit pattern and intermediate non-circuit tracks and in that this assembly is arranged in an injection mould for synthetic material with spacers in the moulding cavity, the spacers pushing the current conductor and non-circuit tracks in the moulding cavity away from each other to at least two relatively offset levels, at which the tracks are held by the spacers during the process of injecting synthetic material.

2. A method as claimed in Claim 1, characterized in that the cutting strokes of the cutter punches have a length of approximately half the copper plate.

3. A method as claimed in Claim 1, characterized in that portions of the conductor tracks are kept free from synthetic material by means of frame-shaped covering slides . 4.

4. A method as claimed in Claim 1, characterized in that at least part of the contact areas of the current conductor tracks are provided with flared holes before the partial cutting operation.

5. A circuit board manufactured by the method claimed in Claims 1 and 2, characterized in that part of the non-circuit tracks are arranged as heat conductors and passed to the outside at the edge of the plate with connection tags.

## Revendications

1. Procédé de fabrication de plaques à circuit imprimé qui sont constituées d'un support en matière plastique en forme de plaque et de bandes conductrices planes formant un motif de circuit, qui présentent des endroits de contact destinés à des composants qui doivent y être connectés, le motif de circuit étant découpé à partir d'une plaque de cuivre dans un outil de coupe comportant des poinçons et des serre-flans et étant encapsulé dans de la matière plastique constituant le support en forme de plaque, caractérisé en ce que la plaque de cuivre n'est entaillée que par une coupe partielle qui laisse subsister une structure encore cohérente de bandes qui seront ultérieurement des bandes de conducteurs de courant du motif de circuit des bandes à vide intermédiaires et que cette structure est introduite dans un moule à injection de matière plastique dont la cavité de moulage contient des organes d'espacement, ces organes d'espacement écartant les bandes de conducteurs de courant et les bandes à vide dans la cavité de moulage dans au moins deux plans décalés l'un de l'autre dans lesquels les bandes sont maintenues par les organes d'espacement pendant l'opération d'injection de matière plastique.

2. Procédé suivant la revendication 1, caractérisé en ce que les trajets de coupe des poinçons d'estampage ont une longueur de l'ordre de la moitié de l'épaisseur de la plaque de cuivre.

3. Procédé suivant la revendication 1, caractérisé en ce que, grâce à des coulisseaux de masquage en forme de réglettes, certaines parties des bandes de conducteurs soient maintenues exemptes de matière plastique.

4. Procédé suivant la revendication 1, caractérisé en ce qu'il est prévu de ménager des élargissements en forme d'ajutages dans au moins une partie des endroits de contact des bandes de conducteurs de courant, avant la coupe partielle.

5. Plaque à circuit imprimé fabriquée par le procédé des revendications 1 et 2, caractérisée en ce qu'une partie des bandes à vide a la forme de conducteurs de chaleur et sort du bord de la plaque sous forme de pattes de connexion.

Fig.1

Fig.2

Fig.3

Fig. 4